# FASCICULE DE BREVET EUROPEEN

(11) **EP 2 409 951 B1**
(45) Date de publication et mention de la délivrance du brevet: **07.09.2016**
(21) Numéro de dépôt: 11173602.1
(22) Date de dépôt: 12.07.2011
(51) Int. Cl.: B81C 1/00, H01B 1/04, H01M 4/139, H01L 29/16, H01M 4/583, H01M 10/04, C01B 31/04

(54) **Procede de fabrication d'une structure comprenant un feuillet de graphene muni de plots metalliques, structure ainsi obtenue et ses utilisations**
Herstellungsverfahren einer Struktur, die ein Graphenblatt mit Metalllötstützpunkten enthält, so erhaltene Struktur und ihre Anwendungen
Manufacturing method for a structure comprising a graphene leaf provided with metal studs, structure thus obtained and its uses

(30) Priorité: 21.07.2010 FR 1055937
(43) Date de publication de la demande: 25.01.2012
(73) Titulaire: Commissariat à l'Énergie Atomique et aux Énergies Alternatives, 75015 Paris (FR); Centre National de la Recherche Scientifique, 75016 Paris (FR)
(72) Inventeur: Zenasni, Aziz, 38610 Gieres (FR); Coraux, Johann, 38500 Coublevie (FR); Ivanova-Hristova, Valentina, 38000 Grenoble (FR); Landis, Stéfan, 38500 Voiron (FR); Pernel, Carole, 38120 Saint Egreve (FR)
(74) Mandataire: Ilgart, Jean-Christophe

(56) Documents cités:
- WO-A1-2009/035213
- US-A1- 2009 155 561
- BABY T T ET AL: "Metal decorated graphene nanosheets as immobilization matrix for amperometric glucose biosensor", SENSORS AND ACTUATORS B, ELSEVIER SEQUOIA S.A., LAUSANNE, CH, vol. 145, no. 1, 4 mars 2010 (2010-03-04), pages 71-77, XP026920949, ISSN: 0925-4005, DOI: DOI:10.1016/J.SNB.2009.11.022 [extrait le 2009-12-11]

## Description

### DOMAINE TECHNIQUE

L'invention se rapporte au domaine de la fabrication de feuillets de graphène.

Plus spécifiquement, l'invention se rapporte à un procédé qui permet de fabriquer une structure comprenant un feuillet de graphène muni, sur l'une de ses faces, de plots métalliques, lesquels plots métalliques sont séparés les uns des autres par un milieu diélectrique choisi parmi l'air et les matériaux diélectriques.

Elle se rapporte également à la structure ainsi obtenue ainsi qu'aux utilisations de cette structure.

Une structure selon l'invention est susceptible d'être utilisée telle quelle dans de très nombreux domaines techniques comme :
- la micro- et la nanoélectronique, par exemple pour la fabrication de transistors du type transistors à effets de champs ou transistors à un électron, ou de structures d'interconnexions pour circuits intégrés ;
- la micro- et la nanoélectromécanique, par exemple pour la fabrication de résonateurs électromécaniques micrométriques ou nanométriques, plus souvent désignés par les sigles MEMS (pour « Micro **E**lectro-**M**echanical **S**ystems ») et NEMS (pour « Nano **E**lectro-**M**echanical **S**ystems ») ;
- la spintronique ;
- le photovoltaïque ; ou encore
- l'affichage à diodes électroluminescentes.

Lorsque les plots métalliques de cette structure sont séparés les uns des autres par un matériau diélectrique, elle est également susceptible d'être utilisée comme produit intermédiaire dans la fabrication d'une structure qui comprend un feuillet de graphène muni, sur l'une de ses faces, d'une membrane poreuse en un matériau diélectrique, ce type de structure présentant, notamment, un intérêt pour le stockage de l'hydrogène, les piles à combustible ainsi que les microbatteries.

### ÉTAT DE LA TECHNIQUE ANTÉRIEURE

Le graphène est un cristal bidimensionnel de carbone, qui présente une structure hexagonale en nid d'abeille.

Ce cristal est doté de propriétés tout à fait surprenantes qui en font actuellement un matériau très prisé de nombreux laboratoires publics et privés.

En effet, le graphène présente, en premier lieu, une mobilité électronique exceptionnelle à température ambiante, pouvant atteindre 20 m²/V.s. A titre de comparaison, la mobilité électronique de l'antimoniure d'indium est, à la température ambiante, 2,5 fois plus faible, celle du silicium est 13 fois plus faible tandis que celle de l'argent est 2 500 fois plus faible.

De plus, le graphène est transparent puisque son épaisseur est celle d'un atome de carbone, très stable chimiquement, très léger tout en étant très résistant sur le plan mécanique (200 fois plus que l'acier).

On connaît un certain nombre de techniques permettant de synthétiser des feuillets de graphène comme l'exfoliation micromécanique d'un cristal de graphite, la réduction électrochimique d'un oxyde de graphène, l'ouverture de nanotubes de carbone, la croissance catalytique du graphène sur substrat métallique ou la sublimation du carbure de silicium.

On connaît également un nanofeuillet de graphène, qui est obtenu par exfoliation thermique d'un oxyde graphitique et qui est ensuite décoré de nanoparticules d'or ou d'un alliage platine-or par une méthode de réduction électrochimique (T.T. Baby et al., Sensors and Actuators B 145 (2010), 71-77, [5]).

Parmi les techniques précitées, la croissance catalytique du graphène sur substrat métallique (voir, par exemple, K.S. Kim et al., Nature (2009), 457, 706-7410, **[1])** semble constituer l'une des voies les plus prometteuses pour synthétiser du graphène à une échelle industrielle et permettre son intégration dans des dispositifs du type dispositifs micro- ou nanoélectroniques, micro- ou nanoélectromécaniques ou autres, qui répondent aux normes industrielles.

En effet, par cette technique, il a été possible de produire des échantillons de graphène de haute qualité cristalline, caractérisée par des domaines monocristallins s'étendant sur plusieurs centaines de micromètres et par une orientation cristallographique unique à l'échelle macroscopique. Des échantillons de graphène aux surfaces centimétriques ont même été obtenus, ce qui n'est pas le cas avec les autres techniques de fabrication du graphène proposées à ce jour.

Toutefois, la fabrication du graphène par croissance catalytique sur substrat métallique présente l'inconvénient majeur de nécessiter ultérieurement un transfert du feuillet de graphène du substrat métallique sur lequel il a été formé vers un support isolant si l'on veut, d'une part, caractériser ce feuillet optiquement et/ou électriquement (c'est-à-dire en étudier les propriétés optiques et/ou électriques) et, d'autre part, l'intégrer dans un dispositif du type précité (voir, par exemple, W. Regan et al., Applied Physics Letters (2010), 96, 113102, **[2]).**

Or, ce transfert met en jeu une succession d'opérations qui impliquent l'utilisation de solutions d'attaque chimique et de résines et qui ont pour effet de générer des défauts à la fois intrinsèques (c'est-à-dire dans le réseau cristallin) et extrinsèques (courbures, impuretés polaires, etc) au graphène, altérant notablement les propriétés de ce matériau.

Au surplus, pour munir le feuillet de graphène de contacts électriques en vue de son intégration dans un dispositif du type précité, il est nécessaire de procéder à des opérations supplémentaires de lithographie, de gravure et de métallisation qui augmentent encore les risques d'altération de ce feuillet.

Les Inventeurs se sont donc fixé pour but de fournir un procédé de fabrication d'un feuillet de graphène de haute qualité cristalline, qui soit exempt de tout transfert de ce feuillet d'un substrat à un autre pour son utilisation ultérieure et, en particulier, pour sa caractérisation ou son intégration dans un dispositif du type dispositif micro- ou nanoélectronique, micro- ou nanoélectromécanique ou autre, qui réponde aux normes industrielles.

Les Inventeurs se sont de plus fixé pour but que ce procédé ait des coûts de mise en oeuvre qui soient compatibles avec une exploitation à une échelle industrielle.

### EXPOSÉ DE L'INVENTION

Ce but et d'autres encore sont atteints par l'invention qui propose, en premier lieu, un procédé de fabrication d'une structure comprenant un feuillet de graphène qui est muni, sur l'une de ses faces, d'une pluralité de plots métalliques, ces plots étant séparés les uns des autres par un milieu diélectrique choisi parmi l'air et les matériaux diélectriques, lequel procédé est caractérisé en ce qu'il comprend :
a) la synthèse, par croissance catalytique en phase vapeur, du feuillet de graphène sur une pluralité de plots métalliques qui sont disposés sur une membrane en un matériau diélectrique ou intégrés dans cette membrane, cette croissance étant catalysée par lesdits plots métalliques ; et éventuellement
b) l'élimination de ladite membrane.

Ainsi, selon l'invention, on fabrique une structure dans laquelle un feuillet de graphène est muni, sur l'une de ses faces, de plots métalliques et ce, sans effectuer un quelconque transfert de ce feuillet d'un substrat à un autre, puisqu'il est synthétisé directement sur ces plots métalliques.

Comme, par ailleurs, les plots métalliques sur lesquels est synthétisé le feuillet de graphène sont disposés sur une membrane en un matériau diélectrique ou intégrés dans cette membrane, il suffit, une fois le feuillet de graphène formé, d'éliminer ou de conserver ladite membrane pour obtenir une structure dans laquelle les plots métalliques assujettis au feuillet de graphène sont séparés les uns les autres par de l'air (si la membrane est éliminée) ou par un matériau diélectrique (si la membrane est conservée).

Ce feuillet de graphène peut donc être aisément caractérisé sur le plan optique et/ou électrique.

Il peut également être directement intégré dans un dispositif du type dispositif de micro- ou nanoélectronique, de micro- ou nanoélectromécanique, ou autre, compte tenu que les plots métalliques dont il est muni peuvent notamment servir de contacts électriques ou d'électrodes.

Dans ce qui précède et ce qui suit, l'expression « matériau diélectrique » est prise dans le sens qui lui est habituellement donné dans le domaine de l'électricité, à savoir qu'elle désigne un matériau non conducteur d'un courant électrique (voir, par exemple, l'« Aide-mémoire de physique : A l'usage des élèves de l'enseignement supérieur scientifique et technique », B. Yavorski & A. Detlaf, Edition Mir, Moscou, 1975, 963 pages, [3]). En d'autres termes, l'expression « matériau diélectrique » est ici synonyme de l'expression « matériau isolant électrique ».

Comme précédemment indiqué, le feuillet de graphène est synthétisé par croissance catalytique en phase vapeur en raison des avantages précédemment exposés que présente cette technique de synthèse du graphène, et ce sont les plots métalliques, qui sont disposés sur la membrane en matériau diélectrique ou intégrés dans cette membrane, qui servent de catalyseurs pour cette croissance.

Dans le cadre de l'invention, la croissance catalytique en phase vapeur du graphène peut être réalisée par toute technique qui permet d'exposer les plots métalliques à des espèces carbonées en phase gazeuse telle que :
- le dépôt chimique en phase vapeur, plus souvent désigné par le sigle CVD (pour « Chemical Vapor Deposition »), sous toutes ses formes : CVD à pression atmosphérique (ou APCVD), CVD basse pression (ou LPCVD), CVD sous vide poussé (ou UHVCVD), CVD assisté par aérosol (ou AACVD), CVD par injection directe liquide (ou DLICVD), CVD thermique rapide (ou RTCVD), CVD initié (ou i-CVD), CVD par couche atomique (ou ALCVD), CVD à fil chaud (ou HWCVD), CVD assisté par plasma (ou PECVD), CVD assisté par plasma déporté (ou RPECVD), CVD assisté par plasma micro-ondes (ou MWPCVD), etc ;
- le dépôt physique en phase vapeur, plus souvent désigné par le sigle PVD (pour « Physical Vapor Deposition »), sous toutes ses formes : PVD par pulvérisation cathodique, PVD par évaporation sous vide, PVD par pulvérisation par faisceau d'ions, PVD par arc, par exemple cathodique, dépôt par laser pulsé, plus souvent désigné par le sigle PLD (pour « Pulsed Laser Deposition »), etc ; et
- le dépôt hybride physico-chimique en phase vapeur, plus souvent désigné par le sigle HPCVD (pour « Hybrid Physical-Chemical Vapor Deposition »).

Néanmoins, on préfère que la croissance catalytique du graphène soit réalisée par dépôt chimique en phase vapeur, cette technique permettant, en effet, de particulièrement bien contrôler la qualité cristalline du feuillet de graphène obtenu.

Auquel cas, la croissance catalytique du graphène est typiquement réalisée en exposant, dans l'enceinte ou dans l'une des enceintes d'un réacteur de CVD, la membrane en matériau diélectrique munie des plots métalliques à un flux gazeux contenant un ou plusieurs hydrocarbures saturés ou insaturés, linéaires, ramifiés ou cycliques, tels que, par exemple, le méthane (CH₄), l'éthane (C₂H₆), le propane (C₃H₈), le butane (C₄H₁₀), l'acétylène (C₂H₂), l'éthylène (C₂H₄), le propylène (C₃H₆), le propyne (C₃H₄), le butylène (C₄H₈), le butyne (C₄H₆), le butadiène (C₄H₆), le benzène (C₆H₆) ou le toluène (C₇H₈), éventuellement en mélange avec de l'hydrogène ou un composé hydrogéné comme, par exemple, NH₃ (dont la présence permet de désoxyder les plots métalliques) et/ou un ou plusieurs gaz neutres du type azote, argon ou hélium, et ce, à une température allant de 200 à 2000°C et à une pression allant de l'ultravide (P ≤ 10⁻⁶ Pa) à la pression atmosphérique (P = 101,325 kPa).

Il se produit ainsi une décomposition des hydrocarbures présents dans le flux gazeux en espèces carbonées, qui se déposent sur les plots métalliques et diffusent sur l'ensemble de la surface de ces plots, puis la formation de noyaux de graphène sur cette surface (nucléation) qui en s'étendant, finissent par se rejoindre et par former un feuillet continu de graphène.

De préférence, on utilise un flux gazeux comprenant un ou plusieurs hydrocarbures en C1 à C3 et, mieux encore, en C1 ou C2 comme le méthane, l'acétylène ou l'éthylène, en mélange avec de l'hydrogène, par exemple dans un rapport hydrocarbure/H₂ de 1 à 10, à une température allant de 800 à 1200°C.

De plus, on préfère que le dépôt chimique en phase vapeur soit un dépôt chimique en phase vapeur basse pression (LPCVD) dans lequel la pression utilisée est sous-atmosphérique tout en étant supérieure à 10⁻⁶Pa.

Dans ces conditions, le temps nécessaire pour obtenir la formation d'un feuillet de graphène est typiquement de 1 à 20 minutes en fonction de la température et de la pression régnant dans l'enceinte, du flux d'agent désoxydant, du temps de désoxydation des plots métalliques, de l'épaisseur des plots métalliques et du flux d'hydrocarbure(s).

La formation du feuillet de graphène sur les plots métalliques peut être contrôlée par spectroscopie Raman, notamment en vérifiant l'apparition des deux pics caractéristiques du graphène, à savoir le pic G à 1580 cm⁻¹ et le pic 2D à 2700 cm⁻¹.

Dans la mesure où, comme précédemment mentionné, le feuillet de graphène est, de préférence, formé par croissance catalytique et où ce sont les plots métalliques, qui sont disposés sur la membrane en matériau diélectrique ou intégrés dans cette membrane, qui servent de catalyseurs pour cette croissance, ces plots sont préférentiellement constitués d'un métal ou d'un alliage de métaux dont le paramètre de maille est en adéquation avec le paramètre de maille du graphène, sachant que l'on considère qu'il y a adéquation entre ces paramètres si le paramètre de maille du métal ou des métaux de l'alliage ne diffère pas de plus de 2% de celui du graphène.

Le paramètre de maille du graphène étant de 2,45 Å, les plots métalliques sont donc, de préférence, constitués d'un métal ou d'un alliage de métaux dont le paramètre de maille est supérieur ou égal à 2,401 Å et inférieur ou égal à 2,499 Å.

Des métaux ayant un tel paramètre de maille sont, notamment, le nickel, le cuivre, le cobalt, le ruthénium, le palladium, l'iridium et le platine.

Parmi ceux-ci, on préfère tout particulièrement le nickel pour son coût, sa haute température de fusion (1455°C) et parce qu'il présente un accord de paramètre de maille particulièrement bon avec le graphène.

Il va de soi que l'utilisation de plots métalliques constitués de l'un des métaux précédemment cités ou d'un alliage de ces métaux n'est pas réservée au seul cas où ces plots sont destinés à servir de catalyseurs à l'étape a) et peut parfaitement envisagée quelle que soit la technique employée pour former le feuillet de graphène.

Conformément à l'invention, les plots métalliques peuvent être répartis sur la membrane en matériau diélectrique ou dans cette membrane de façon quelconque. De manière similaire, ces plots peuvent avoir des dimensions quelconques et être séparés les uns des autres par des distances quelconques.

Toutefois, on préfère que les plots métalliques soient répartis de façon ordonnée et, plus spécialement, qu'ils forment un réseau, c'est-à-dire un ensemble de lignes parallèles entre elles et de colonnes perpendiculaires à ces lignes.

Auquel cas, ce réseau est, de préférence, à pas régulier, c'est-à-dire que la distance qui sépare deux plots adjacents est constante ou sensiblement constante.

Par ailleurs, on préfère que la plus grande étendue des plots métalliques mesurée dans une direction parallèle au plan de la membrane en matériau diélectrique - qui correspond au diamètre de ces plots dans le cas où ils ont la forme d'un cylindre de révolution ou sensiblement cette forme - soit de dimension nanométrique, et que la distance qui sépare deux plots métalliques adjacents soit, elle-aussi, de dimension nanométrique.

Dans ce qui précède et ce qui suit, on qualifie de « nanométrique », une dimension qui est au moins égale à 1 nanomètre mais qui est inférieure à 1 micromètre.

De préférence, le procédé selon l'invention comprend, de plus, une étape de réalisation des plots métalliques, laquelle étape comprend le remplissage d'ouvertures que comporte un support avec un métal ou un alliage métallique.

En liaison avec ce qui précède, on préfère que les ouvertures de ce support soient réparties de façon ordonnée et, plus spécialement, qu'elles forment un réseau, c'est-à-dire un ensemble de lignes parallèles entre elles et de colonnes perpendiculaires à ces lignes et que ce réseau soit à pas régulier, c'est-à-dire que la distance qui sépare deux plots adjacents est constante ou sensiblement constante.

Par ailleurs, on préfère que la plus grande étendue des ouvertures du support mesurée dans une direction parallèle au plan de ce support soit de dimension nanométrique et que la distance qui sépare deux ouvertures adjacentes de ce support soit, elle aussi, de dimension nanométrique.

De manière particulièrement préférée, le support est constitué par la membrane en matériau diélectrique et les ouvertures de ce support correspondent à des pores que comporte cette membrane, avant remplissage desdites ouvertures par le métal ou l'alliage métallique, qui forment un réseau et dont la plus grande étendue mesurée dans une direction parallèle au plan de ladite membrane est de dimension nanométrique.

Cette membrane peut notamment être une membrane d'alumine, de silice, d'un matériau de formule SiᵥO_{w}CₓH_{z} ou SiᵥO_{w}CₓN_{y}H_{z} dans laquelle v, w, x, y et z tous différents de 0, d'un polymère tel qu'un polycarbonate ou un polyéthylènetéréphtalate, ou d'un copolymère séquencé tel qu'un copolymère de polyméthacrylate de méthyle et de polyoxyde d'éthylène (PPMA/POE).

Des membranes de ce type sont pour certaines, disponibles dans le commerce (membranes de polycarbonate et de polyéthylènetéréphtalate par exemple). Quand ce n'est pas le cas, elles peuvent être réalisées par des procédés d'oxydation anodique (par exemple, dans le cas d'une membrane d'alumine) qui permet d'obtenir une grande densité de pores (10⁹-10¹² pores/cm³) présentant un diamètre de 10 à 500 nm, de lithographie ou photolithographie suivie d'une gravure sélective, de nanoimpression assistée par UV, tous ces procédés étant bien connus de l'homme du métier.

Avantageusement, les pores de la membrane en matériau diélectrique sont des pores traversants, ce qui permet de réaliser le remplissage de ces pores par électrodéposition qui est une technique hautement sélective tout en étant peu coûteuse.

Toutefois, d'autres techniques peuvent être utilisées pour le remplissage des pores comme le dépôt chimique en phase vapeur (PVD), le dépôt de couches atomiques (ALD pour « **A**tomic **L**ayer **D**eposition »), le dépôt de couches atomiques assisté par plasma (PEALD pour « **P**lasma-**E**nhanced **A**tomic **L**ayer **D**eposition ») ou encore le dépôt chimique métallo-organique en phase vapeur (MOCVD pour « **M**etal **O**rganic **C**hemical **V**apor **D**eposition »).

L'invention a également pour objet une structure telle qu'obtenue par le procédé précédemment décrit.

Cette structure est caractérisée en ce qu'elle comprend un feuillet de graphène qui est muni, sur l'une de ses faces, de plots métalliques, ces plots étant séparés les uns des autres par un milieu diélectrique choisi parmi l'air et les matériaux diélectriques et étant répartis sur ladite face du feuillet de graphène de façon ordonnée, c'est-à-dire de façon à former un réseau consistant en un ensemble de lignes parallèles entre elles et de colonnes perpendiculaires à ces lignes.

L'invention a encore pour objet les utilisations de cette structure.

Comme précédemment indiquée, cette structure est susceptible d'être utilisée, en premier lieu, telle quelle dans la fabrication de dispositifs micro- ou nanoélectroniques, micro- ou nanoélectromécaniques, spintroniques, photovoltaïques ou d'affichage à diodes électroluminescentes.

Toutefois, lorsque le milieu diélectrique qui sépare les plots métalliques est un matériau diélectrique, elle est également susceptible d'être utilisée dans la fabrication d'une structure comprenant un feuillet de graphène muni, sur l'une de ses faces, d'une membrane poreuse en un matériau diélectrique.

Auquel cas, cette utilisation comprend l'élimination des plots métalliques de ladite structure.

La structure ainsi obtenue présente notamment un intérêt pour la réalisation de dispositifs dévolus au stockage de l'hydrogène, de piles à combustible et de microbatteries.

D'autres caractéristiques et avantages de l'invention ressortiront du complément de description qui suit, qui se rapporte à des exemples de mise en oeuvre du procédé selon l'invention et qui se réfère aux figures annexées.

Dans ces exemples, on appelle « nanoplots », « nanopores » et « nanofils », des plots, des pores et des fils ayant la forme d'un cylindre de révolution ou sensiblement cette forme et dont le diamètre est nanométrique.

Il va de soi que ces exemples ne sont donnés qu'à titre d'illustrations de l'objet de l'invention et ne constituent en aucun cas une limitation de cet objet.

### BRÈVE DESCRIPTION DES FIGURES

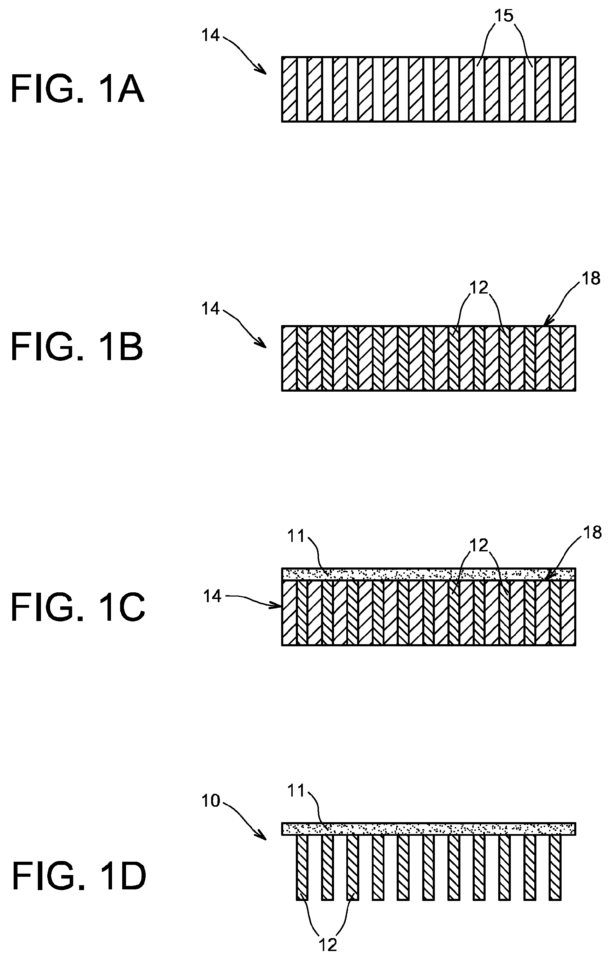

Les figures 1A à 1D illustrent, sous une forme schématique, un premier mode de mise en oeuvre du procédé selon l'invention, conçu pour fabriquer une structure comprenant un feuillet de graphène qui est muni, sur l'une de ses faces, d'un réseau de nanoplots métalliques à pas régulier, et dans laquelle ces nanoplots sont séparés les uns des autres par de l'air.

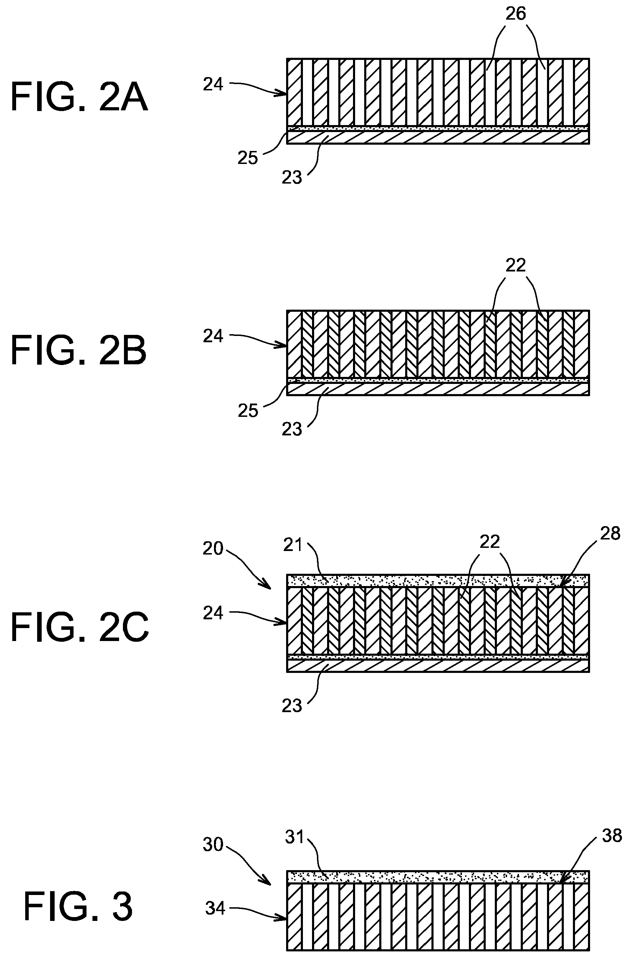

Les figures 2A à 2C illustrent, sous une forme schématique, un deuxième mode de mise en oeuvre du procédé selon l'invention, conçu pour fabriquer une structure comprenant un feuillet de graphène qui est muni, sur l'une de ses faces, d'un réseau de nanoplots métalliques à pas régulier, et dans laquelle ces nanoplots sont séparés par un matériau diélectrique.
La figure 3 illustre, sous une forme schématique, une structure comprenant un feuillet de graphène qui est muni, sur l'une de ses faces, d'une membrane poreuse en un matériau diélectrique, et ayant été obtenue à partir de la structure illustrée sur la figure 2C.

Pour des raisons de clarté, les dimensions des différents éléments représentés sur ces figures ne sont pas en proportion avec leurs dimensions réelles.

### EXPOSÉ DÉTAILLÉ DE MODES DE MISE EN OEUVRE PARTICULIERS

### Exemple 1 :

On se réfère tout d'abord aux figures 1A à 1D qui illustrent schématiquement un premier mode de mise en oeuvre du procédé selon l'invention, conçu pour fabriquer une structure 10 qui, comme visible sur la figure 1D, comprend un feuillet de graphène 11 qui est solidaire d'un réseau, à pas régulier, de nanoplots métalliques 12, plus précisément de nickel, et dans laquelle ces nanoplots sont séparés les uns des autres par de l'air.

Dans ce mode de mise en oeuvre, le procédé selon l'invention comprend les 4 étapes suivantes :
1) la préparation d'une membrane d'alumine comportant un réseau de nanopores traversants, à pas régulier, par oxydation anodique d'une feuille d'aluminium ;
2) l'élaboration de nanofils de nickel dans les nanopores de la membrane d'alumine ainsi réalisée, par électrodéposition ;
3) la synthèse d'un feuillet de graphène sur la surface des nanofils ainsi élaborés, par LPCVD ; puis
4) l'élimination de la membrane d'alumine par gravure chimique.

Ces étapes sont décrites de manière détaillée ci-après.

### * Préparation de la membrane nanoporeuse d'alumine :

Une feuille d'aluminium mesurant 1 µm d'épaisseur est, tout d'abord, soumise à un recuit sous atmosphère neutre (argon, hélium ou azote), pendant 2 heures à 500°C, pour renforcer la taille des grains du métal et obtenir des conditions homogènes de croissance des nanopores lors des opérations ultérieures d'oxydation anodique.

Puis, cette feuille est immergée pendant 30 secondes dans une solution à 5% de soude, préalablement chauffée à 60°C, pour la décaper, après quoi elle est immergée pendant 10 secondes dans une solution aqueuse d'acide nitrique 1,5 M pour la neutraliser.

L'une des faces de la feuille d'aluminium est ensuite soumise à un électropolissage pendant 20 secondes, que l'on réalise à température ambiante, dans un bain standard d'électropolissage (acide perchlorique à 65%/éthanol/2-butoxyéthanol/eau), et en appliquant une tension continue de 40 volts entre cette feuille, qui sert d'anode, et une contre-électrode constituée d'une plaque de graphite.

La rugosité moyenne de la face ainsi électropolie est d'environ 3 nm sur une zone de 3 µm².

Cette face est alors soumise à une première oxydation anodique d'une durée de 15 heures, que l'on réalise dans un bain à température de 15°C, dans une solution aqueuse à 3% d'acide oxalique à 0,5 M, et en appliquant une tension continue de 40 volts entre la feuille d'aluminium, qui sert d'anode, et une contre-électrode consistant en une grille de platine.

La couche d'alumine formée au cours de cette oxydation anodique est éliminée par une gravure humide, que l'on réalise à 60°C en utilisant une solution aqueuse contenant 0,2 mole/L d'acide chromique et 0,4 mole/L d'acide phosphorique.

Puis, la face précédemment anodisée de la feuille d'aluminium est soumise à une deuxième oxydation anodique d'une durée de 5 heures, que l'on réalise dans les mêmes conditions que celles de la première oxydation anodique.

On obtient ainsi la membrane d'alumine 14 qui est illustrée, vue en coupe transversale, sur la figure 1A et qui présente un réseau de nanopores traversants 15.

Ces nanopores ont un diamètre moyen de 70 nm environ et sont séparés les uns des autres par une distance sensiblement constante, de l'ordre de 110 nm.

### * Elaboration des nanofils de nickel :

Les nanofils de nickel étant élaborés par électrodéposition, il est nécessaire de rendre conductrices les extrémités des nanopores qui débouchent sur l'une des faces de la membrane d'alumine avant de procéder à cette électrodéposition.

De ce fait, une couche d'or de 10 nm d'épaisseur est, tout d'abord, déposée sur l'une des faces de la membrane d'alumine par évaporation sous vide, en utilisant un masque pour que ce dépôt n'ait lieu que sur les extrémités des nanopores débouchant sur cette face.

Puis, l'électrodéposition est réalisée, à la température de 20°C, dans un bain électrolytique composé de 200 g/L d'un mélange de chlorure de nickel (NiCl₂) et d'eau (1/1, v/v), de 120 g/L d'un mélange de sulfate de nickel (NiSO₄) et d'eau (1,7, v/v), et de 50 g/L d'acide borique, et dont le pH a été préalablement ajusté à 4 par addition de soude, en appliquant pendant 90 minutes une tension continue de 10 volts entre l'électrode de travail, qui est constituée par la couche d'or recouvrant les extrémités des nanopores, et une contre-électrode qui est constituée d'une plaque d'acier inoxydable.

Le nickel déposé en excès, c'est-à-dire correspondant à la partie des nanofils s'étant formée en dehors des nanopores de la membrane d'alumine, est éliminé par un polissage mécano-chimique sélectif, lequel est réalisé en utilisant une solution à 0,1% de peroxyde d'hydrogène comme oxydant, et un slurry à 4,6% en poids de particules d'alumine mesurant en moyenne 180 nm de diamètre comme abrasif. La vitesse linéaire de polissage est de 10 cm/minute et la pression appliquée est de 5,1 psi (34,47 kPa). Le temps de polissage pour chaque parcours est ajusté en fonction de l'épaisseur du nickel devant être éliminé.

On obtient ainsi la structure qui est illustrée, vue en coupe transversale, sur la figure 1B et dans laquelle la membrane d'alumine 14 comprend un réseau de nanoplots de nickel 12 qui sont intégrés dans cette membrane et dont l'une des extrémités, référencée 17, affleure l'une des faces, référencée 18, de ladite membrane.

Ces nanoplots de nickel, dont le diamètre moyen et l'espacement sont les mêmes que ceux des nanopores dans lesquels ils ont été formés (70 nm environ pour le diamètre, 110 nm environ pour l'espacement), sont propres à servir de catalyseurs dans l'étape suivante.

### * Synthèse du feuillet de graphène :

La structure illustrée sur la figure 1B est introduite dans l'enceinte d'un réacteur de LPCVD, et disposée sur une plaque dont on porte la température à 1000°C par pas de 50°C et que l'on maintient à cette température pendant 10 minutes, sous une pression de 0,5 torr (0,0666 kPa) et un flux d'argon de 200 cm³/ minute.

Puis, les conditions de température et de pression étant maintenues constantes, la structure est successivement soumise à :
- un flux d'hydrogène (ayant un rôle désoxydant) de 1000 cm³/minute pendant 2 minutes ; et
- un flux d'hydrogène de 1000 cm³/minute auquel on ajoute un flux d'éthylène de 200 cm³/minute.

Après quoi, elle est refroidie soit dans l'enceinte du réacteur de LPCVD soit dans une chambre dévolue à cet effet, sous vide ou sous atmosphère d'un gaz neutre du type azote, argon ou hélium, à raison de 10°C/minute.

On obtient ainsi la structure qui est illustrée, vue en coupe transversale, sur la figure 1C et qui comprend un feuillet de graphène 11 s'étendant sur toute la face 18 de la membrane d'alumine 14 et s'étant formé par nucléation de graphène sur les nanoplots de nickel 12, croissance des noyaux ainsi constitués en plans de graphène et confluence de ces plans.

### * Elimination de la membrane d'alumine :

La membrane d'alumine de la structure illustrée sur la figure 1C est éliminée par une gravure chimique que l'on réalise en immergeant pendant 10 minutes la structure dans une solution aqueuse de soude 2 M dont la température est de 20°C. Après quoi, la structure est rincée à l'eau désionisée plusieurs fois (au moins 5 fois) puis elle est séchée pendant 30 minutes dans une enceinte chauffée à 300°C, sous un flux d'azote.

On obtient ainsi la structure 10 qui est illustrée, vue en coupe transversale, sur la figure 1D, qui comprend un feuillet de graphène 11 qui est solidaire du réseau de nanoplots de nickel 12 et dans laquelle ces nanoplots sont séparés les uns des autres par de l'air.

### Exemple 2 :

On se réfère à présent aux figures 2A à 2C qui illustrent schématiquement un deuxième mode de mise du procédé selon l'invention qui se distingue du précédent en ce qu'il est conçu pour fabriquer une structure dans laquelle les nanoplots de nickel sont séparés les uns des autres par un matériau diélectrique, en l'espèce du SiOCH.

De ce fait, dans ce mode de mise en oeuvre, le procédé selon l'invention comprend les 3 étapes suivantes :
1) la préparation, par PECVD suivi d'une lithographie par faisceau d'électrons, d'une membrane de SiOCH comportant un réseau de nanopores traversants, à pas régulier ;
2) l'élaboration, par électrodéposition, de nanofils de nickel dans les nanopores de la membrane ainsi réalisée ; et
3) la synthèse, par LPCVD, d'un feuillet de graphène sur les nanofils de nickel ainsi élaborés.

### * Préparation de la membrane nanoporeuse de SiOCH :

Une couche de nickel de 5 nm d'épaisseur est, tout d'abord, déposée par PVD sur la surface d'un substrat de silicium d'orientation cristalline de 100, en utilisant un masque permettant de déposer cette couche de nickel uniquement sur des zones prédéterminées, correspondant aux futurs emplacements des nanopores de la membrane de SiOCH prévue pour être formée ensuite sur ce substrat.

Puis, une couche de SiOCH de 200 nm d'épaisseur est déposée par PECVD sur la face du substrat partiellement recouverte de nickel.

Ce dépôt est réalisé dans l'une des chambres à couplage capacitif d'une Centura™ DXZ 200 nm de la société Applied Materials, en disposant le substrat sur un porte-substrat chauffé à 300°C et en utilisant les paramètres opératoires suivants :
- plasma radiofréquence : 13,56 MHz ;
- pression de travail : 5 torrs (666 Pa) ;
- puissance : 600 W ;
- flux de diéthoxyméthylsilane (DEMS) : 1000 cm³/min ;
- flux d'hélium : 1000 cm³/min ;
- durée du dépôt : 30 secondes.

Après refroidissement, la couche de SiOCH ainsi formée est soumise à une lithographie par faisceau d'électrons, que l'on réalise comme décrit par T. Raluca et al. dans Microelectronic Engineering (2006), 83, 926, [4], en utilisant un masque pour que le fond des nanopores formés par cette lithographie dans ladite couche de SiOCH coïncide avec les zones du substrat ayant été recouvertes de nickel.

On obtient ainsi la structure qui est illustrée, vue en coupe transversale, sur la figure 2A.

Cette structure comprend un substrat de silicium 23 qui est localement recouvert d'une couche de nickel 25, lesquels sont eux-mêmes recouverts d'une membrane de SiOCH 24 qui présente un réseau de nanopores traversants 26, dont le diamètre moyen est de 40 nm environ et qui sont séparés les uns des autres par une distance constante de l'ordre de 40 nm.

### * Elaboration des nanofils de nickel :

Les nanofils de nickel sont réalisés en suivant le même protocole d'électrodéposition que celui utilisé dans l'exemple 1 ci-avant à ceci près que, dans ce cas, c'est la couche de nickel 25 qui sert d'électrode de travail.

Là également, le nickel déposé en excès, c'est-à-dire correspondant à la partie des nanofils s'étant formée en dehors des nanopores de la membrane d'alumine, est éliminé par un polissage mécano-chimique sélectif, que l'on réalise de la même manière que dans l'exemple 1 ci-avant.

On obtient ainsi la structure qui est illustrée, vue en coupe transversale, sur la figure 2B et dans laquelle la membrane de SiOCH 24 comprend un réseau de nanoplots de nickel 22 qui sont intégrés dans cette membrane et dont les extrémités affleurent chacune l'une des faces de ladite membrane.

Ces nanoplots de nickel, dont le diamètre moyen et l'espacement sont les mêmes que ceux des nanopores dans lesquels ils ont été formés (40 nm environ pour le diamètre, 40 nm environ pour l'espacement), sont propres à servir de catalyseurs dans l'étape suivante.

### * Synthèse du feuillet de graphène :

Le feuillet de graphène est synthétisé en suivant le même protocole de LPCVD que celui utilisé dans l'exemple 1 ci-avant.

On obtient, à l'issue de cette étape, la structure 20 qui est illustrée, vue en coupe transversale, sur la figure 2C.

Cette structure comprend un feuillet de graphène 21 qui s'étend sur toute la face, référencée 28, de la membrane de SiOCH 24 qui est opposée à celle en contact avec le substrat de silicium 23, et qui s'est formé par nucléation de graphène sur les nanoplots de nickel 22 de cette membrane, croissance des noyaux ainsi constitués en plans de graphène et confluence de ces plans.

Cette structure peut être utilisée telle quelle, par exemple dans des structures d'interconnexions pour circuits intégrés ou des nanosystèmes électromécaniques (NEMS).

Toutefois, pour d'autres applications, il est possible, de retirer les nanoplots de nickel 22 de la membrane de SiOCH 24, par exemple par une gravure humide que l'on réalise en immergeant quelques minutes la structure 20 dans une solution aqueuse de chlorure ferrique (ClFe₃) 1 M.

Une gravure de ce type permet, en effet, de retirer les nanoplots de nickel 22 de la structure 20 sans que des produits gazeux ou des précipités ne se forment et, par conséquent, sans que le feuillet de graphène 21 ne soit endommagé.

On obtient ainsi la structure 30 qui est illustrée, vue en coupe transversale, sur la figure 3.

Cette structure comprend un feuillet de graphène 31 qui s'étend sur l'une des faces, référencée 38, d'une membrane nanoporeuse de SiOCH 34.

### REFERENCES CITEES

[1] K.S. Kim et al., Nature (2009), 457, 706-7410
[2] W. Regan et al., Applied Physics Letters (2010), 96, 113102
[3] « Aide-mémoire de physique : A l'usage des élèves de l'enseignement supérieur scientifique et technique », B. Yavorski & A. Detlaf, Edition Mir, Moscou, 1975, 963 pages
[4] T. Raluca et al., Microelectronic Engineering (2006), 83, 926
[5] T.T. Baby et al., Sensors and Actuators B 145 (2010), 71-77

## Revendications

1. Procédé de fabrication d'une structure comprenant un feuillet de graphène qui est muni, sur l'une de ses faces, d'une pluralité de plots métalliques, ces plots étant séparés les uns des autres par un milieu diélectrique choisi parmi l'air et les matériaux diélectriques, lequel procédé est **caractérisé en ce qu'**il comprend :
a) la synthèse, par croissance catalytique en phase vapeur, du feuillet de graphène sur une pluralité de plots métalliques qui sont disposés sur une membrane en un matériau diélectrique ou intégrés dans cette membrane, cette croissance étant catalysée par lesdits plots métalliques ; et éventuellement
b) l'élimination de ladite membrane.

2. Procédé selon la revendication 1, **caractérisé en ce que** la croissance catalytique du graphène est réalisée par dépôt chimique en phase vapeur.

3. Procédé selon la revendication 2, **caractérisé en ce que** le dépôt chimique en phase vapeur est réalisé en utilisant un flux gazeux comprenant un ou plusieurs hydrocarbures, éventuellement en mélange avec de l'hydrogène et/ou un ou plusieurs gaz neutres, à une température allant de 200 à 2000°C et à une pression allant de l'ultravide à la pression atmosphérique.

4. Procédé selon la revendication 2 ou la revendication 3, **caractérisé en ce que** le dépôt chimique en phase vapeur est réalisé en utilisant un flux gazeux comprenant un ou plusieurs hydrocarbures en C1 à C3 et, de préférence, en C1 ou C2, éventuellement en mélange avec de l'hydrogène ou un composé hydrogéné et/ou un ou plusieurs gaz neutres, à une température allant de 800 à 1200°C et à une pression inférieure à la pression atmosphérique mais supérieure à 10⁻⁶ Pa.

5. Procédé selon l'une quelconque des revendications précédentes, **caractérisé en ce que** les plots métalliques sont constitués d'un métal ou d'un mélange de métaux dont le paramètre de maille ne diffère pas de plus de 2% de celui du graphène.

6. Procédé selon la revendication 5, **caractérisé en ce que** les plots métalliques sont constitués d'un métal ou d'un mélange de métaux choisis parmi le nickel, le cuivre, le cobalt, le ruthénium, le palladium, l'iridium et le platine.

7. Procédé selon la revendication 6, **caractérisé en ce que** les plots métalliques sont constitués de nickel.

8. Procédé selon l'une quelconque des revendications précédentes, **caractérisé en ce que** les plots métalliques forment un réseau.

9. Procédé selon la revendication 8, **caractérisé en ce que** le réseau est à pas régulier.

10. Procédé selon la revendication 8 ou la revendication 9, **caractérisé en ce que** la plus grande étendue des plots métalliques mesurée dans une direction parallèle au plan de la membrane en matériau diélectrique est au moins égale à 1 nanomètre et inférieure à 1 micromètre.

11. Procédé selon l'une quelconque des revendications 8 à 10, **caractérisé en ce que** la distance qui sépare deux plots métalliques adjacents est au moins égale à 1 nanomètre et inférieure à 1 micromètre.

12. Procédé selon l'une quelconque des revendications précédentes, **caractérisé en ce qu'**il comprend, de plus, une étape de réalisation des plots métalliques, laquelle étape comprend le remplissage d'ouvertures que comporte un support avec un métal ou un alliage métallique.

13. Procédé selon la revendication 12, **caractérisé en ce que** les ouvertures du support forment un réseau.

14. Procédé selon la revendication 13, **caractérisé en ce que** le réseau est à pas régulier.

15. Procédé selon l'une quelconque des revendications 12 à 14, **caractérisé en ce que** la plus grande étendue des ouvertures du support mesurée dans une direction parallèle au plan de ce support est au moins égale à 1 nanomètre et inférieure à 1 micromètre.

16. Procédé selon l'une quelconque des revendications 12 à 15, **caractérisé en ce que** la distance qui sépare deux ouvertures adjacentes du support est au moins égale à 1 nanomètre et inférieure à 1 micromètre.

17. Procédé selon l'une quelconque des revendications 12 à 16, **caractérisé en ce que** le support est constitué par la membrane en matériau diélectrique et **en ce que** les ouvertures de ce support correspondent à des pores que comporte cette membrane, avant remplissage desdites ouvertures par le métal ou l'alliage métallique, qui forment un réseau et dont la plus grande étendue mesurée dans une direction parallèle au plan de ladite membrane est au moins égale à 1 nanomètre et inférieure à 1 micromètre.

18. Procédé selon la revendication 17, **caractérisé en ce que** la membrane en matériau diélectrique est une membrane d'alumine, de silice, d'un matériau de formule SiᵥO_{w}C_{y}H_{z} ou SiᵥO_{w}CₓN_{Y}H_{z} dans laquelle v, w, x, y et z tous différents de 0, d'un polymère ou d'un copolymère séquencé.

19. Structure, **caractérisée en ce qu'**elle comprend un feuillet de graphène qui est muni, sur l'une de ses faces, de plots métalliques, ces plots étant séparés les uns des autres par un milieu diélectrique choisi parmi l'air et les matériaux diélectriques et étant répartis sur ladite face du feuillet de graphène de façon à former un réseau consistant en un ensemble de lignes parallèles entre elles et de colonnes perpendiculaires à ces lignes.

20. Utilisation d'une structure telle que définie dans la revendication 19 dans la fabrication de dispositifs micro- ou nanoélectroniques, micro- ou nanoélectromécaniques, spintroniques, photovoltaïques ou d'affichage à diodes électroluminescentes.

21. Utilisation d'une structure telle que définie dans la revendication 19 et dans laquelle le milieu diélectrique qui sépare les plots métalliques est un matériau diélectrique, dans la fabrication d'une structure comprenant un feuillet de graphène qui est muni, sur l'une de ses faces, d'une membrane poreuse en un matériau diélectrique, laquelle utilisation comprend l'élimination des plots métalliques de la structure telle que définie dans la revendication 19.

## Patentansprüche

1. Verfahren zum Herstellen einer Struktur, enthaltend ein Graphenblatt, das an einer seiner Flächen mit einer Mehrzahl von Metallstiften versehen ist, wobei diese Stifte durch ein dielektrisches Medium voneinander getrennt sind, das ausgewählt ist aus Luft und dielektrischen Materialien, wobei das Verfahren **dadurch gekennzeichnet ist, dass** es umfasst:
a) die Synthese des Graphenblatts durch katalytisches Dampfphasenwachstum auf einer Mehrzahl von Metallstiften, die an einer Membran aus dielektrischem Material angeordnet sind oder in dieser Membran integriert sind, wobei dieses Wachstum durch die Metallstifte katalysiert wird; und gegebenenfalls
b) das Entfernen der Membran.

2. Verfahren nach Anspruch 1, **dadurch gekennzeichnet, dass** das katalytische Wachstum von Graphen durch chemische Dampfabscheidung erfolgt.

3. Verfahren nach Anspruch 2, **dadurch gekennzeichnet, dass** die chemische Dampfabscheidung unter Verwendung eines Gasstroms mit einem oder mehreren Kohlenwasserstoffen, gegebenenfalls als Gemisch mit Wasserstoff und/oder einem oder mehreren neutralen Gasen, bei einer Temperatur von 200 bis 2000 °C und bei einem Druck vom Ultrahochvakuum bis zum Atmosphärendruck erfolgt.

4. Verfahren nach Anspruch 2 oder Anspruch 3, **dadurch gekennzeichnet, dass** die chemische Dampfabscheidung unter Verwendung eines Gasstroms mit einem oder mehreren Kohlenwasserstoffen von C1 bis C3 und vorzugsweise von C1 bzw. C2, gegebenenfalls als Gemisch mit Wasserstoff oder mit einer Wasserstoffverbindung und/oder einem oder mehreren neutralen Gasen bei einer Temperatur von 800 bis 1200 °C und bei einem Druck, der unter dem Atmosphärendruck liegt aber höher als 10⁻⁶ Pa ist, erfolgt.

5. Verfahren nach einem der vorangehenden Ansprüche, **dadurch gekennzeichnet, dass** die Metallstifte aus einem Metall oder einem Metallgemisch bestehen, dessen Gitterparameter sich nicht um mehr als 2 % von dem von Graphen unterscheidet.

6. Verfahren nach Anspruch 5, **dadurch gekennzeichnet, dass** die Metallstifte aus einem Metall oder einem Metallgemisch bestehen, ausgewählt aus Nickel, Kupfer, Kobalt, Ruthenium, Palladium, Iridium und Platin.

7. Verfahren nach Anspruch 6, **dadurch gekennzeichnet, dass** die Metallstifte aus Nickel bestehen.

8. Verfahren nach einem der vorangehenden Ansprüche, **dadurch gekennzeichnet, dass** die Metallstifte ein Netz bilden.

9. Verfahren nach Anspruch 8, **dadurch gekennzeichnet, dass** das Netz eine gleichmäßige Teilung hat.

10. Verfahren nach Anspruch 8 oder Anspruch 9, **dadurch gekennzeichnet, dass** die größte Erstreckung der Metallstifte in einer Richtung parallel zur Ebene der Membran aus dielektrischem Material gemessen zumindest gleich 1 Nanometer und kleiner als 1 Mikrometer ist.

11. Verfahren nach einem der Ansprüche 8 bis 10, **dadurch gekennzeichnet, dass** der Abstand, der zwei aneinandergrenzende Metallstifte voneinander trennt, zumindest gleich 1 Nanometer und kleiner als 1 Mikrometer ist.

12. Verfahren nach einem der vorangehenden Ansprüche, **dadurch gekennzeichnet, dass** es ferner einen Schritt des Herstellens von Metallstiften umfasst, welcher Schritt das Füllen von Öffnungen, die in einem Träger vorgesehen sind, mit einem Metall oder einer Metalllegierung umfasst.

13. Verfahren nach Anspruch 12, **dadurch gekennzeichnet, dass** die Öffnungen des Trägers ein Netz bilden.

14. Verfahren nach Anspruch 12, **dadurch gekennzeichnet, dass** das Netz eine gleichmäßige Teilung hat.

15. Verfahren nach einem der Ansprüche 12 bis 14, **dadurch gekennzeichnet, dass** die größte Erstreckung der Öffnungen des Trägers in einer Richtung parallel zur Ebene dieses Trägers gemessen zumindest gleich 1 Nanometer und kleiner als 1 Mikrometer ist.

16. Verfahren nach einem der Ansprüche 12 bis 15, **dadurch gekennzeichnet, dass** der Abstand, der zwei aneinandergrenzende Öffnungen des Trägers voneinander trennt, zumindest gleich 1 Nanometer und kleiner als 1 Mikrometer ist.

17. Verfahren nach einem der Ansprüche 12 bis 16, **dadurch gekennzeichnet, dass** der Träger aus der Membran aus dielektrischem Material besteht und dass die Öffnungen dieses Trägers Poren entsprechen, welche diese Membran aufweist, und zwar vor dem Füllen der Öffnungen mit dem Metall bzw. der Metalllegierung, die ein Netz bilden und deren größte Erstreckung in einer Richtung parallel zur Ebene der Membran gemessen zumindest gleich 1 Nanometer und kleiner als 1 Mikrometer ist.

18. Verfahren nach Anspruch 17, **dadurch gekennzeichnet, dass** die Membran aus dielektrischem Material eine Membran aus Aluminiumoxid, Siliciumoxid, aus einem Material der Formel SiᵥO_{w}C_{y}H_{z} oder SiᵥO_{w}CₓN_{y}H_{z}, wobei v, w x, y und z alle verschieden von 0 sind, aus Polymer oder aus einem Blockcopolymer besteht.

19. Struktur, **dadurch gekennzeichnet, dass** sie ein Graphenblatt enthält, das an einer seiner Flächen mit Metallstiften versehen ist, wobei diese Stifte durch ein dielektrisches Medium voneinander getrennt sind, das ausgewählt ist aus Luft und dielektrischen Materialien, und über die Fläche des Graphenblatts so verteilt sind, dass sie ein Netz bilden, das aus einer Gesamtheit von zueinander parallelen Zeilen und senkrecht zu diesen Zeilen verlaufenden Spalten besteht.

20. Verwendung einer Struktur wie in Anspruch 19 definiert zum Herstellen von mikro- bzw. nanoelektronischen, mikro- bzw. nanoelektromechanischen, spintronischen, fotovoltaischen Vorrichtungen oder Anzeigevorrichtungen mit LED-Dioden.

21. Verwendung einer Struktur wie in Anspruch 19 definiert, bei welcher das dielektrische Medium, das die Metallstifte voneinander trennt, ein dielektrisches Material ist, zum Herstellen einer Struktur, enthaltend ein Graphenblatt, das an einer seiner Flächen mit einer porösen Membran aus dielektrischem Material versehen ist, wobei die Verwendung die Entfernung der Metallstifte von der Struktur wie in Anspruch 19 definiert umfasst.

## Claims

1. Method of manufacturing a structure comprising a graphene sheet that is provided, on one of the faces thereof, with a plurality of metal pins, these pins being separated from one another by a dielectric medium chosen from air and dielectric materials, said method being **characterised in that** it comprises:
a) the synthesis, by vapour phase catalytic growth, of the graphene sheet on a plurality of metal pins that are disposed on a membrane made from dielectric material or integrated in this membrane, this growth being catalysed by said metal pins; and optionally
b) the removal of said membrane.

2. Method according to claim 1, **characterised in that** the catalytic growth of the graphene is carried out by chemical vapour deposition.

3. Method according to claim 2, **characterised in that** the chemical vapour deposition is carried out using a gaseous flow comprising one or more hydrocarbons, optionally in a mixture with hydrogen and/or one or more neutral gases, at a temperature ranging from 200°C to 2000°C and at pressure ranging from ultrahigh vacuum to atmospheric pressure.

4. Method according to claim 2 or claim 3, **characterised in that** the chemical vapour deposition is carried out using a gaseous flow comprising one or more C1 to C3 hydrocarbons, preferably C1 or C2, optionally in a mixture with hydrogen or a hydrogenated compound and/or one or more neutral gases, at a temperature ranging from 800°C to 1200°C and at a pressure below atmospheric pressure but higher than 10⁻⁶ Pa.

5. Method according to any one of the preceding claims, **characterised in that** the metal pins consist of a metal or a mixture of metals, the mesh parameter of which does not differ by more than 2% from that of the graphene.

6. Method according to claim 5, **characterised in that** the metal pins consist of a metal or a mixture of metals chosen from nickel, copper, cobalt, ruthenium, palladium, iridium and platinum.

7. Method according to claim 6, **characterised in that** the metal pins consist of nickel.

8. Method according to any one of the preceding claims, **characterised in that** the metal pins form a lattice.

9. Method according to claim 8, **characterised in that** the lattice has a regular pitch.

10. Method according to claim 8 or claim 9, **characterised in that** the greatest extent of the metal pins measured in a direction parallel to the plane of the membrane made from dielectric material is at least equal to 1 nanometre and less than 1 micrometre.

11. Method according to any one of claims 8 to 10, **characterised in that** the distance that separates two adjacent metal pins is at least equal to 1 nanometre and less than 1 micrometre.

12. Method according to any one of the preceding claims, **characterised in that** it also comprises a step of producing metal pins, which step comprises the filling of openings in a support with a metal or metal alloy.

13. Method according to claim 12, **characterised in that** the openings in the support form a lattice.

14. Method according to claim 13, **characterised in that** the lattice has a regular pitch.

15. Method according to any one of claims 12 to 14, **characterised in that** the greatest extent of the openings in the support measured in a direction parallel to the plane of the support is at least equal to 1 nanometre and less than 1 micrometre.

16. Method according to any one of claims 12 to 15, **characterised in that** the distance that separates two adjacent openings in the support is at least equal to 1 nanometre and less than 1 micrometre.

17. Method according to any one of claims 12 to 16, **characterised in that** the support is formed by the membrane made from dielectric material and **in that** the openings in the support correspond to pores in this membrane, before filling of said openings by the metal or metal alloy, which form a lattice and the greatest extent of which measured in a direction parallel to the plane of said membrane is at least equal to 1 nanometre and less than 1 micrometre.

18. Method according to claim 17, **characterised in that** the membrane made from dielectric material is a membrane of alumina, silica, a material of formula SiᵥO_{w}C_{y}H_{z} or SiᵥO_{w}CₓN_{y}H_{z} in which v, w, x, y and z are all different from 0, a polymer or a sequenced copolymer.

19. Structure, **characterised in that** it comprises a graphene sheet that is provided, on one of the faces thereof, with metal pins, these pins being separated from one another by a dielectric medium chosen from air and dielectric materials and being disposed on said surface to as to form a lattice consisting of a set of rows parallel to each other and columns perpendicular to these rows.

20. Use of a structure as defined in claim 19 in the manufacture of micro- or nanoelectronic, micro- or nanoelectromechanical, spintronic, photovoltaic or light emitting diode display devices.

21. Use of a structure as defined in claim 19 and in which the dielectric medium that separates the metal pins is dielectric material, in the manufacture of a structure comprising a graphene sheet that is provided, on one of the faces thereof, with a porous membrane made from a dielectric material, which use comprises the removal of the metal pins from the structure as defined in claim 19.
